# EUROPEAN PATENT APPLICATION

(11) **EP 3 968 126 A1**
(43) Date of publication of application: **16.03.2022**
(21) Application number: 20207108.0
(22) Date of filing: 12.11.2020
(51) Int. Cl.: G06F 1/18, G06F 1/20, H05K 5/02, H05K 7/20

(54) **A MODULAR COMPUTER CASE SHARING MONITOR ASSEMBLING BRACKET WITH POWER SUPPLIER**

(30) Priority: 09.09.2020 TW 109130984
(71) Applicant: Chen, Yen-Wei, Taoyuan City 320 (TW)
(72) Inventor: Chen, Yen-Wei, Taoyuan City 320 (TW)
(74) Representative: Cabinet Chaillot

(57) **Abstract**

A modular computer case **(10)** includes a horizontal computer case, a case cover **(20)** arranged on the opening **(11)** of the computer case **(10),** forming an air exchange system on the case cover **(20);** an assembling bracket kit **(40),** forming a modular base **(60)** with the case cover **(20);** a predetermined monitor **(80)** which can be installed on the computer case **(10)** to form a modular computer case **(10)** sharing monitor assembling bracket with power supplier **(50),** and the front section of the case cover **(20)** has multiple air suction holes **(211)** for sucking in the external air and exhausting through the heat dissipation through holes **(23)** arranged at the rear section of the case cover **(20),** so as to form a high effect heat dissipate system.

## Description

### BACKGROUND OF THE INVENTION

### 1. Field of the Invention:

The invention relates to a modular computer case, especially to one that provides consumer more custom options, it can be combined with the monitor in to one piece and be modular, and sharing the assemble bracket of the monitor with the power supplier to achieve having a modular computer case with high-speed cooling system.

### 2. Description of the Related Art

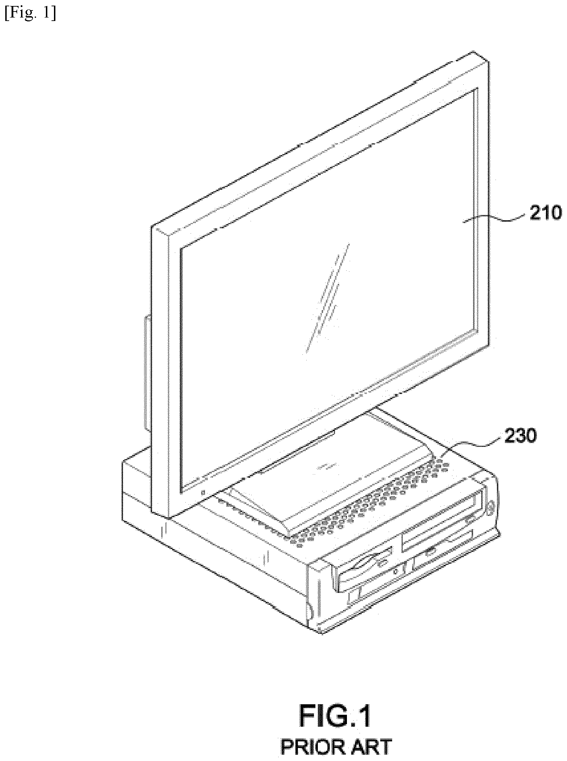

FIG. 1 illustrates a horizontal computer **230** having the monitor **210** on the top, FIG. 1 illustrates a vertical computer **240** with the monitor **210** arranged separately; both of them are having computer and monitor separately, so they occupy more space, and the tangled and exposed connection wire will affect the appearance.

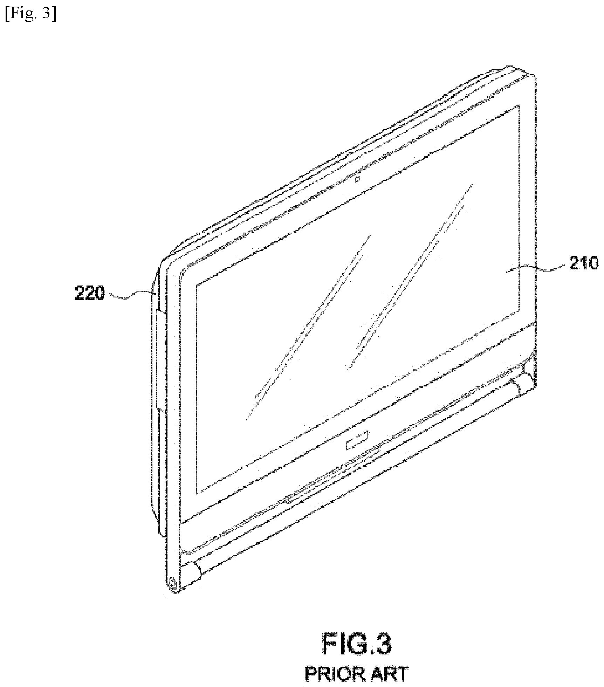

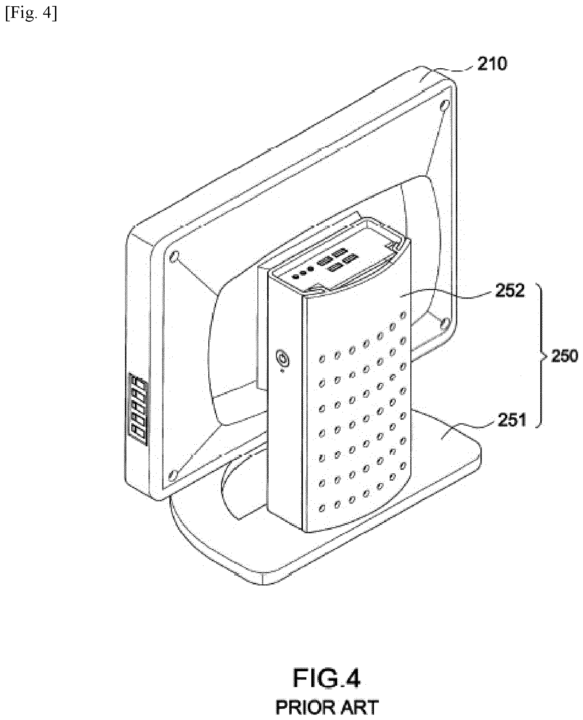

In order to achieve the purpose of reduce the size of desktop computer, AIO computer (All In One) is appeared; as FIG. 3 as showing, the power supplier, motherboard, hard disk, graphics card and other components are all assembled in the housing **220** that arranged at the rear side of the monitor **210**; FIG. 4 illustrates a Taiwan Patent No. M369601 which having the monitor **210** arranged at the front side of the support mechanism **250**, the support mechanism **250** includes a base **251** and a support bracket **252** connected with the base **251**, and the power supplier, motherboard, hard disk, graphics card and other components are all assembled in support bracket **252**; both computers above mentioned are AIO type, since their size is reduced, they are favored by many users; however, the space inside the AIO computer is too small for heat dissipation, so the continuous accumulation of heat will greatly reduce the life of related parts, so the heat dissipation problem forms a fatal flaws to AIO computers.

Moreover, with the development trend of computer computing frequency getting higher and higher, facing the application of high level interface, the AIO computer cannot use the transfer method, and the interface such as USB3.1 and Thunderbolt provided by the mainboard I/O port are set in a place within the user's reach, further resulting in having the problem that high level USB3.1 is not convenience to used. Also, PIO computer (Part In One) allow the user assemble the computer into one piece by himself, it allow the user to choose the graphics card, CPU, hard disc, and etc., to fulfill the requirement of different user, and the PIO computer is having the monitor installed with the computer case into one piece.

Also, the computing performance and level of computer parts are proportional to power consumption, the only way to solve the heat dissipation problem is by air changing, in order to achieve making computer case having high power consumption computer units combine with the monitor, and having more custom option, the present invention intends to solve below problems:
1. The vertical computer has the disadvantage that no matter how small the size is, there is always a space be taken for placing computer on the desk.
2. The horizontal computer does not have the mechanism for hanging the monitor, so three main heat resource units, the power supplier, the main board and the graphics card, are arranged inside the computer case, as Patent No. Cn210534649 U showing, there is no other space for installing larger fan, the heat dissipate way is limited by the small fans installed on above mention three units, so when the outer air is suck in the case will create a backpressure and can only dissipate the heat slowly like stirring the air, resulting in extremely bad heat dissipate efficiency; moreover, the air suction holes do not have any protection, if the air suction holes are too big, foreign objects may get into the case and damage components, and there are also concerns about electromagnetic waves (EMI/EMC) leakage and the problem that the monitor may easily get tip over.
3. The all-in-one machine using the monitor frame as the case with non-modular market components, AIO, and the one using modular market component, PIO, both of them have to installed aforementioned three main heat resource unit together into the case, so the heat dissipation problem is worse than the horizontal computer; This type of computer has the problem of low power consumption level, but also because of the monitor size, width ratio, curved surface, and whether it supports 3D features, these users' demand options are all limited, which completely violates the individualized demands and propositions of personal computers, so the sales of AIO and PIO have declined year by year, when NUC computer is released which, since it only has a size of a lunch box with lower power consumption.
4. The horizontal computer case combined with the monitor assembling bracket, as Patent No. CN 210534649 U showing, the cooling fan in the all-in-one computer case can only suck in external air from the ventilation holes on the main cover plate to slowly stir and dissipate heat. Therefore, the residual pressure of the fan is too low to use the side ventilation holes, in addition, there are the problems of foreign objects falling into the case and external radiation that harmful to the human body. Therefore, this all-in-one computer must use a power supplier that cannot support high power consumption, output voltage DC12V and output current 10A, it is also specifically stated that the all-in-one computer does not have a graphics card expansion slot, so the monitor assembly bracket is randomly set on the back of the computer with a first threading hole, the first threading hole has six screw holes for fixing the metal connection bracket around the threading hole, and it has not solved the tipping backward problem of all-in-one computer.
5. Four types of computers above mentioned, including computer with graphics card expansion slot, have not considered the problem that cannot be overcome by the development of high-frequency technology, and can no longer use the transfer of the USB3.0 in low-speed interface, and setting the mainboard I/O ports and Thunderbolt at the user's reachable location, resulting in the disadvantage that the use of high-speed interfaces is not as convenient as low-speed interfaces, which hinders the development and business opportunities of computer peripheral products.
6. Thus, the present invention seeks to improve the methods and thought of designing and manufacturing computer case to solve the problems of AIO computer made by the conventional technology, and further make the monitor frame as a PIO computer case, and overcome the problems that happens on personalized arrangement, heat dissipation effect, and miniaturization purpose.

### SUMMARY OF THE INVENTION

It is a primary objective of the present invention to provide a modular computer case sharing monitor assembling bracket with power supplier, assemble all component with the monitor to form an all-in-one computer, and install the power supplier outside the computer case for miniaturization the space that computer taken on the desk and extends the life of components.

In order to achieve the above objectives, the present invention including: a computer case, which is a horizontal PC case having an upward opening, inside the opening has a containing space for installing related computer units, the rear side of the computer case has a first opening for installing a predetermined I/O port of a display card, at the other side of the computer case has a second opening for installing a predetermined I/O port of a mainboard; a case cover set at the opening of computer case, the case cover has multiple air suction holes arranged at the front section; the rear section of the case cover has an upward heat dissipation through holes for installing at least a predetermined cooling fan or water cooling radiator with fan, the multiple air suction holes allow the predetermined fan inside the computer case to suck the outside air and then go through the heat dissipation through holes and to form a high-speed cooling ventilation system, and a mounting hole for arranging a predetermined power supplier; an assembling bracket kit having an upright structure, a power supplier assembling positioning kit arranged at the outer periphery of the upright structure, and a monitor assembling positioning kit, wherein the power supplier assembling positioning kit and the monitor assembling positioning kit are arranged at the outer periphery of the upright structure, and the bottom end of the upright structure is secured on the case cover, the monitor assembling positioning kit further has a junction at the front side for making the case cover and the assembling bracket kit composing a modular base; and the modular base can be installed quickly on the computer case to form a modular computer case sharing monitor assembling bracket with power supplier.

Also, the related computer units can be contained inside the computer case including: a mainboard, a first suction fan, a display card, and a second suction fan which combined on the display card, and inside the case cover can arrange a PCIe slot for installing PCIe extension cable, the PCIe slot is arranged correspondingly to the display card and the mainboard.

Also, the heat dissipation through holes is for installing a predetermined cooling fan, using the first suction fan and second suction fan to suck in the outside cold air and then exhaust the heat inside the computer case by the predetermined cooling fan, the predetermined cooling fan includes a water cooling radiator.

Also, the composition of the air suction holes includes: at least an air suction port arranged at the front section of the case cover, and on the any side of the air suction port has multiple interval plates; a first-type cover mask having multiple first hollow holes arranged at the front section of the case cover for making interval plates to be partial exposed, and the first-type cover mask is covered on the air suction port and the interval plates of the case cover for making the air suction port and the interval plates form multiples passages or through holes that avoid foreign objects and electromagnetic wave leakage by sucking in the outside air from lateral side.

Also, the air suction port at the front section of the case cover and the heat dissipation through hole at the rear section further include a second-type cover mask with larger area, the second-type cover mask not only has the first hollow holes arranged at the first-type cover mask but also has a second hollow hole that make the mounting holes and the positioning hole to be exposed at the rear section of the case cover, the second-type cover mask covers the air suction port and part of the interval plates, between each of the interval plates remain the air suction holes for exchanging air; the second-type cover mask has multiple meshes arranged correspondingly to the arrangement of the heat dissipation through holes, and the predetermined cooling fan can be arranged below the heat dissipation through holes and not be protruding out of the top surface of the case cover.

Also, the structure of the air suction holes is multiple air suction holes form in one piece at the front section of the case cover.

Also, the mounting holes of the computer case is for installing with the bottom of the power supplier, using the power supplier assembling positioning kit to secure the predetermined power supplier at the lateral side of the upright structure to let the exhaust mesh which arranged on the top of the power supplier be installed upward and be exposed outside the computer case, and the mounting holes can let the predetermined power supply cable of the power supplier to set through and further make the computer units inside the computer case to be electrically connected, and the case cover has a positioning hole corresponds to the bottom of the upright structure to secure the upright structure on the case cover by a positioning unit.

Also, the shape of the upright structure includes column, bar, and plate.

Also, the front side of the junction of the monitor assembling positioning kit is for installing a predetermined monitor, and the monitor assembling positioning kit further includes a pivot and an adjustment unit in order to adjust the height of the monitor assembling positioning kit according to the upright structure and to adjust the angle of the predetermined monitor according the monitor assembling positioning kit.

Also. at the rear side of the case cover and the computer case has a pivot mechanism for making the case cover able to be open for assembling and maintaining task inside the computer case.

With the features disclosed above, the present invention has below benefits: having a high-speed cooling ventilation system, and installing the power supplier outside the PIO computer case for miniaturization the space that computer taken on the desk and extends the life of components.

### BRIEF DESCRIPTION OF THE DRAWINGS

FIG. 1 is a schematic diagram illustrating arrangement of the conventional horizontal computer;

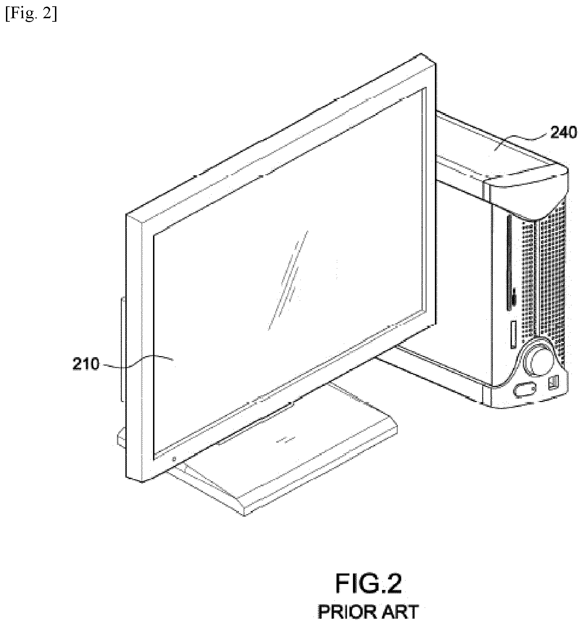

FIG. 2 is a schematic diagram illustrating arrangement of the conventional vertical computer;
FIG. 3 is a schematic diagram illustrating arrangement of an all-in-one computer;
FIG. 4 is a schematic diagram illustrating arrangement of another type all-in-one computer;
FIG. 5 is an exploded perspective view of the present invention;
FIG. 6A is a perspective view of the modular base of the present invention without the first-type cover mask;
FIG. 6B is a perspective view of the modular base of the present invention with the first-type cover mask;
FIG. 6C is an exploded perspective view of the modular base and the first-type cover mask of the present invention;
FIG. 6D is an assembly perspective view of the modular base and the first-type cover mask of the present invention;
FIG. 6E is a perspective view of the air suction holes of the present invention which forming into one piece at the front section of the case cover;
FIG. 7 is a perspective view of the first assemble step of the present invention;
FIG. 8 is a perspective view of the second assemble step of the present invention;
FIG. 9 is a perspective view of the third assemble step of the present invention;
FIG. 10 is another assembly perspective view of the present invention;
FIG. 11 is a schematic diagram illustrating the heat dissipation of the present invention;
FIG. 12 is a schematic diagram illustrating the case cover of the present invention while opened;
FIG. 13 is a schematic diagram illustrating the connect units of the monitor during adjusting;
FIG. 14 is a structure perspective view of the bracket kit in another embodiment of the present invention;
FIG. 15 is a perspective view of the cooling fan in another embodiment of the present invention.

### DETAILED DESCRIPTION OF THE PREFERRED EMBODIMENT

For better understanding of present invention, I provide the embodiment and drawing enclosed for detailed description. Those who skilled in the art can understand purpose, the feature and benefit of the present invention from the contents disclosed in this specification. Kindly noted that the present invention can be implemented or applied through other different specific embodiments and based on different viewpoints various details in this specification can be various changed without departing from the spirit of the present invention. In addition, the drawings attached to the present invention are merely a schematic illustration and they are not depicted in actual dimensions. The following embodiments will further describe the related technical content of the present invention in detail, but the disclosed content is not intended to limit the technical scope of the present invention.

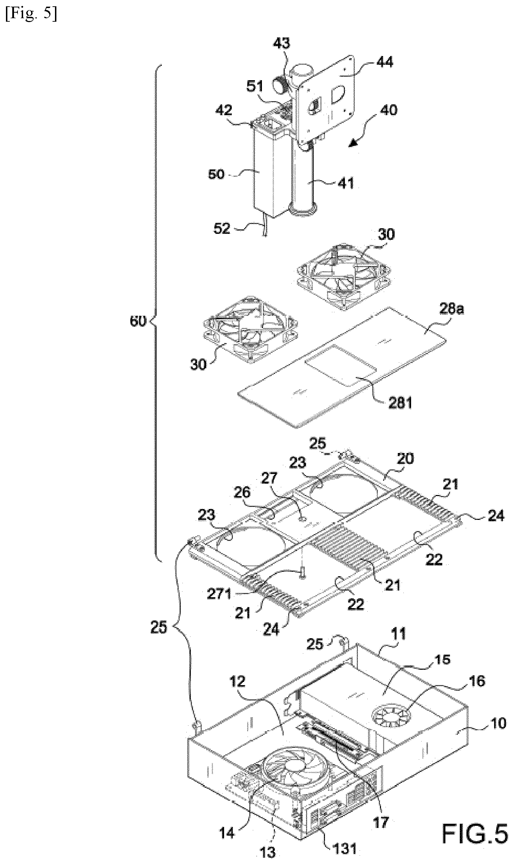

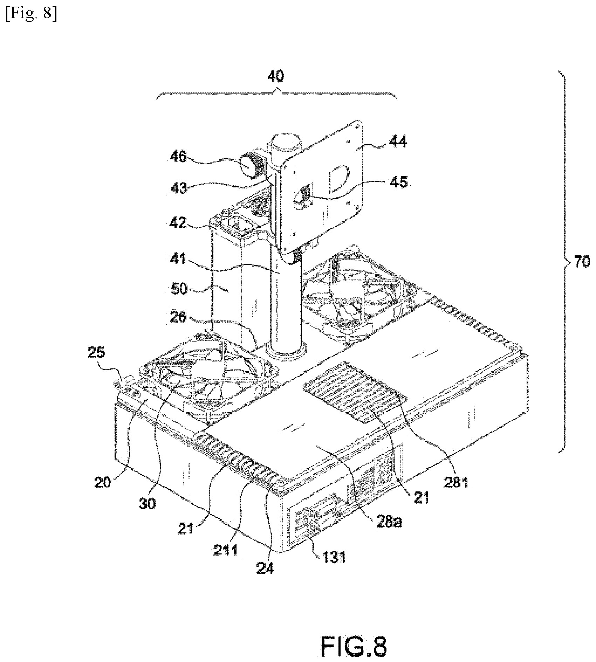

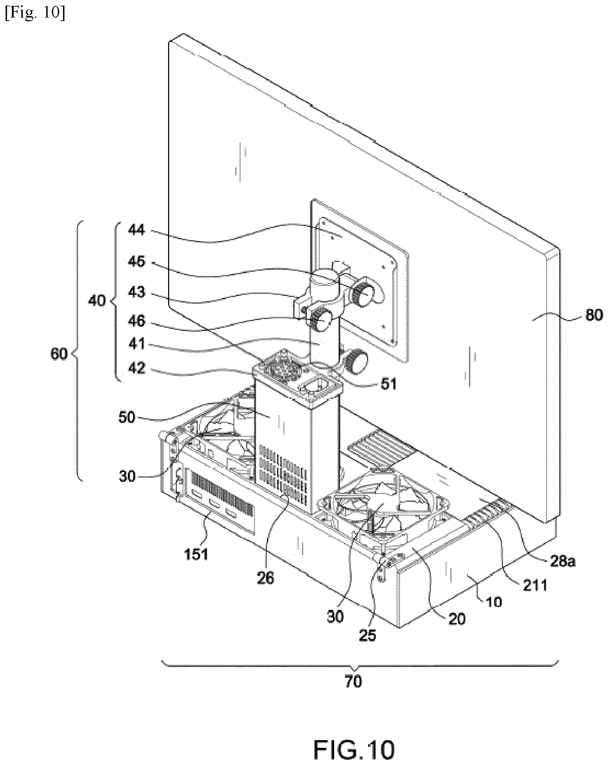

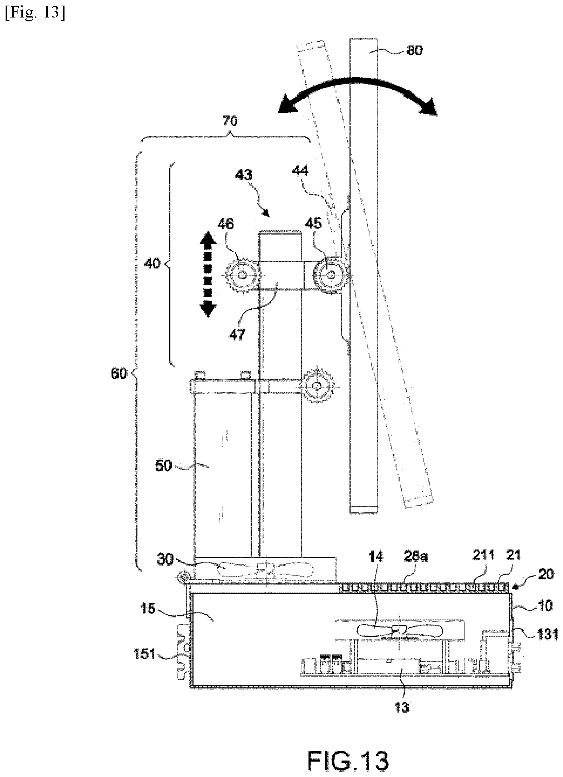

Referring to FIGS. 5-15, the present invention is a modular computer case sharing monitor assembling bracket with power supplier, comprising: a computer case 10, which is a horizontal PC case having a upward opening **11**, inside the opening **11** has a containing space **12** for installing related computer unit, in this embodiment, the related computer units can be contained inside the computer case **10** including: a mainboard **13**, a first suction fan **14**, a display card **15**, a second suction fan **16** which combined on the display card **15**, and etc.

A case cover **20** set at the opening **11** of computer case **10**, the case cover **20** has multiple air suction holes **211** arranged at the front section; the rear section of the case cover **20** has an upward heat dissipation through holes **23** for installing at least a predetermined cooling fan **30** or water cooling radiator **31** with fan, the multiple air suction holes **211** allow the predetermined fan inside the computer case **10** to suck the outside air and then go through the heat dissipation through holes **23** and to form a high-speed cooling ventilation system, and a mounting hole **26** for arranging a predetermined power supplier **50**.

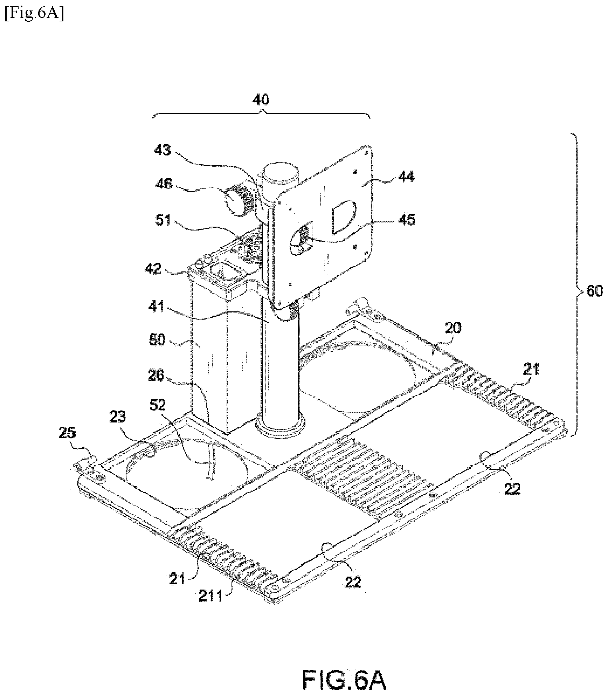

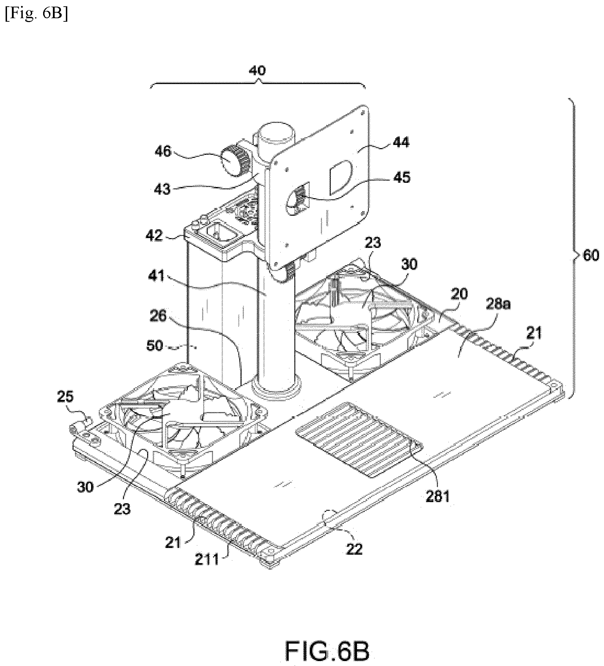

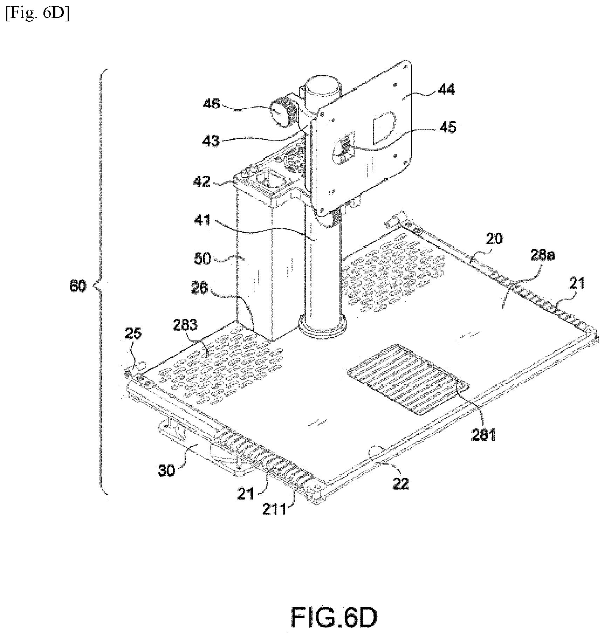

Referring to FIGS. 6A-6B, in this embodiment, the composition of the air suction holes **211** includes: at least an air suction port **22** arranged at the front section of the case cover **20**, and on the any side of the air suction port **22** has multiple interval plates **21**, like a shape of fish scales or fence; a first-type cover mask **28a** having multiple first hollow holes **281** arranged at the front section of the case cover **20** for making interval plates 21 to be partial exposed, and the first-type cover mask **28a** is covered on the air suction port **22** and the interval plates **21** of the case cover **20** for making the air suction port **22** and the interval plates **21** form multiples passages or through holes that avoid foreign objects and electromagnetic wave leakage by sucking in the outside air from lateral side.

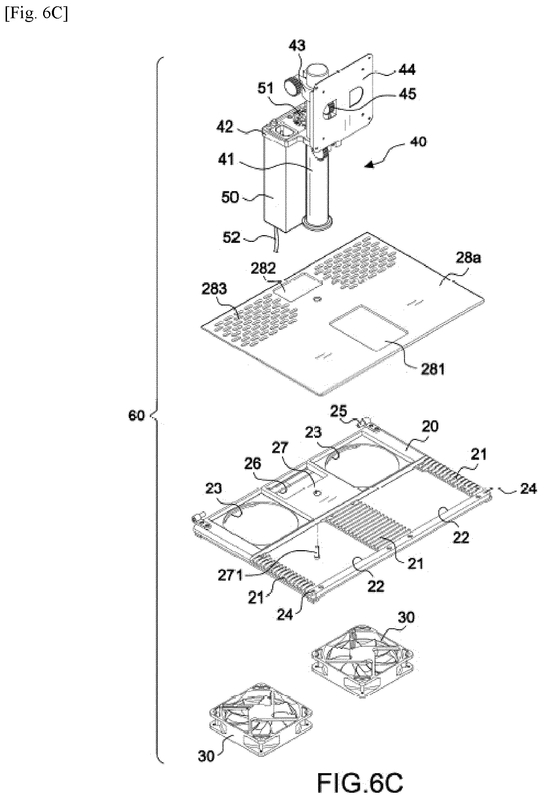

Referring to FIGS. 6C-6D, in this embodiment, the air suction port **22** at the front section of the case cover **20** and the heat dissipation through hole **23** at the rear section further include a second-type cover mask **28b** with larger area, the second-type cover mask **28b** not only has the first hollow holes **281** arranged at the first-type cover mask **28a** but also has a second hollow hole **282** that make the mounting holes **26** and the positioning hole **27** to be exposed at the rear section of the case cover **20**, the second-type cover mask **28b** covers the air suction port **22** and part of the interval plates **21**, between each of the interval plates **21** remain the air suction holes **211** for exchanging air; the second-type cover mask **28b** has multiple meshes **283** arranged correspondingly to the arrangement of the heat dissipation through holes **23**, and the predetermined cooling fan **30** can be arranged below the heat dissipation through holes **23** and not be protruding out of the top surface of the case cover **20**.

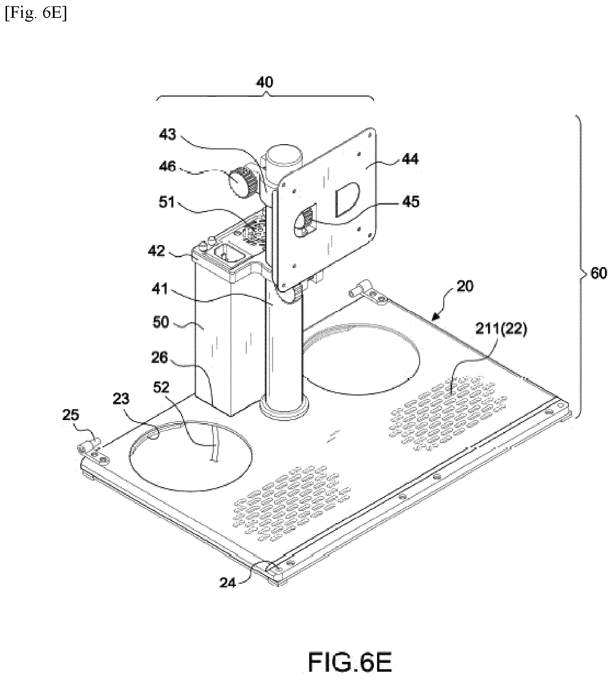

Referring to FIG. 6E, in another embodiment, the structure of the air suction holes **211** is multiple air suction holes **211** form in one piece at the front section of the case cover **20**, and the quantity of the air suction holes **211** can be different by the requirement; in above embodiment, at place where the air suction port **22** arranged or the place near to the air suction port **22**, the air suction holes **211** provide the effect of the air suction passage.

Also, the rear section of the case cover **20** has at least an upward heat dissipation through hole **23** for installing predetermined cooling fan **30** or water cooling system, and the heat dissipation through hole **23** and the air suction holes **211** further form a high-speed cooling ventilation system. For installing the case cover **20** on the computer case **10**, on the four corners of the case cover **20** have screw holes **24**, and two corners at the rear section have pivot mechanism **25** for making the case cover **20** of the computer case **10** enable to be lifted off for assembling and maintaining task inside the computer case **10**; the two screw holes **24** of the two corners at the front section can be buckle, not shown in drawing, in order to let the front section of the case cover **20** achieves fast open and lock effect.

An assembling bracket kit **40** having an upright structure **41**, a power supplier assembling positioning kit **42** arranged at the outer periphery of the upright structure **41**, and a monitor assembling positioning kit **43**, wherein the power supplier assembling positioning kit **42** and the monitor assembling positioning kit **43** are arranged at the outer periphery of the upright structure **41**, and the bottom end of the upright structure **41** is secured on the case cover **20**, the monitor assembling positioning kit **43** further has a junction **44**; in this embodiment, the shape of the upright structure **41** includes column, bar, and plate, but the present invention is not limited to such application.

In this embodiment, the mounting holes **26** of the case cover **20** is for installing with the bottom of a predetermined power supplier **50**, using the power supplier assembling positioning kit **42** to secure the predetermined power supplier **50** at the lateral side of the upright structure **41** to let the exhaust mesh **51** which arranged on the top of the power supplier **50** be installed upward and be exposed outside the computer case **10**, and the mounting holes **26** can let the predetermined power supply cable **52** of the power supplier **50** to set through and further make the computer units inside the computer case **10** to be electrically connected, and the case cover **20** has a positioning hole **27** corresponds to the bottom of the upright structure **41** to secure the upright structure **41** on the case cover **20** by a positioning unit, and make the power supplier **50** be arranged at the rear side of the assembling bracket kit **40** and outside the computer case **10**, which also means the power supplier **50** is exposed outside the computer case **10** for making the case cover **20** and the assembling bracket kit **40** form a modular base **60**; and the modular base **60** make the case cover **20** to be convenient installed on the computer case 10; and the assembling bracket kit **40** can install the monitor **80** quickly to form a modular computer case **70** sharing monitor assembling bracket with power supplier **50**.

Also, at least a predetermined cooling fan **30** which can be arranged on the heat dissipation through hole **23**, and using the first suction fan **14** and second suction fan **16** to suck in the outside cold air **A1** and then exhaust the heat inside the computer case **10** by the predetermined cooling fan **30**, and the type of the predetermined cooling fan **30** is not limited.

In this embodiment, the second-type cover mask **28b** can be a metal or transparent glass plate; But the present invention is not limited to such application. The following embodiment is based on the first-type cover mask **28**.

The first-type cover mask **28** made of metal or other antimagnetic material is for covering on the air suction port **22** of the case cover **20** to prevent the outward radiation of the magnetic wave EMI/EMC of the computer units and avoid the foreign objects form getting in the computer case **10**, and the first-type cover mask **28** can be temporally removed while necessary.

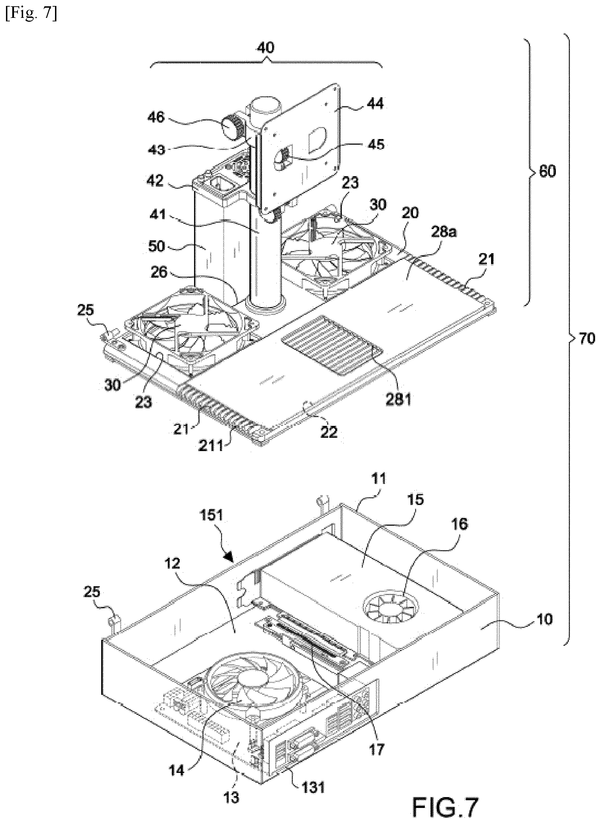

FIGS. 7-10 are illustrating the steps for assembling a modular computer case **70** sharing monitor assembling bracket with power supplier; First, securing the bottom end of the upright structure **41** at the positioning hole **27** of the case cover **20** by positioning units **271**; then, securing the top end of the power supplier **50** with the power supplier assembling positioning kit **42**, and let the predetermined power supply cable **52** set through the mounting holes **2)** of the case cover **20** and let the bottom end stands on the case cover **20**, and further let it be arranged at the rear side of the assembling bracket kit **40**; then, set the monitor assembling positioning kit **43** at the outer periphery of the upright structure **41** and the above the power supplier assembling positioning kit **42**, and let the junction **44** toward the front side of the assembling bracket kit **40**, as FIG. 6A showing; then, choosing the main board **13**, the first suction fan **14**, the display card **15** and the second suction fan **16** which combined on the display card **15** installed inside the containing space **12** of the computer case **10** of the horizontal computer.

In this embodiment, a first opening **151** for installing a predetermined I/O port of a display card **15** is arranged at the rear side of the computer case **10**; a second opening **131** for installing a predetermined I/O port of a mainboard **13** is arranged at the front or left or right side of the computer case **10**; and inside the case cover **20** further has a PCIe slot **17** for installing PCIe extension cable, the PCIe slot **17** is arranged correspondingly to the display card **15** and the mainboard **13**. Therefore, the present invention can set the mainboard **13** I/O ports at the user's reachable location, so the user can directly use the USB 3.0, USB3.1, USB 4 and Thunderbolt of the mainboard **13**.

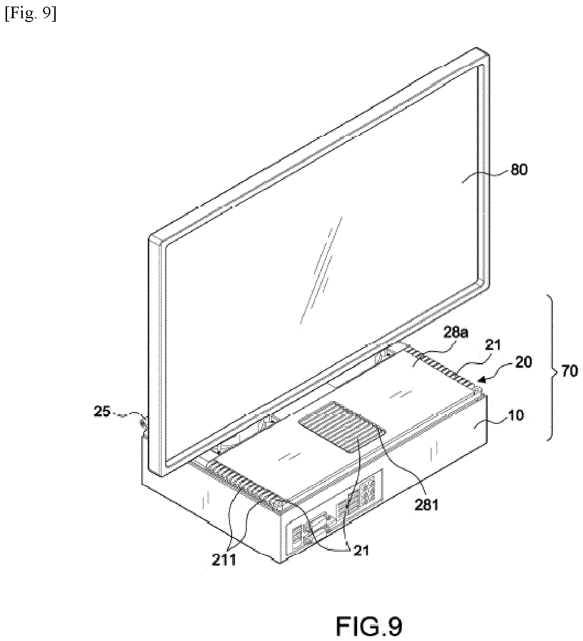

Also, the present invention can choose to arrange two cooling fan **30** above the two heat dissipation through hole **23** of the rear side of the case cover **20**, and cover the first-type cover mask **28a** on the air suction port **22** of the case cover **20**, as FIG. 7 showing; then, arrange pivot mechanisms **25** with the hinge at the two corner of the rear section of the case cover **20**, and arrange securing mechanisms with the screw hole **24** at the two corner of the front section of the case cover **20** making the case cover **20** be arranged on the computer case **10**, as FIG. showing; moreover, installing the monitor **80** at the front side of the junction **44** of the monitor assembling positioning kit **43** will complete a modular computer case sharing monitor assembling bracket with power supplier, as FIGS. 9-10 showing.

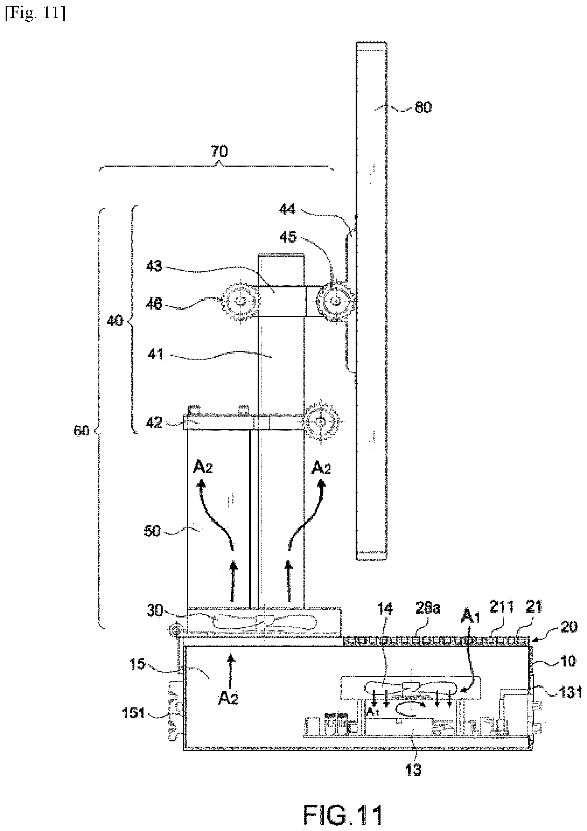

FIG. 11 is a schematic diagram illustrating the heat dissipation of the present invention; wherein, the cold air **A1** is sucked into the computer case **10** from the two air suction ports **22** which arranged at the front side of the case cover **20**, then by stirring of the first suction fan **14** and the second suction fan **16** will exchange heat with the main board **13** and display card **15**, and the heat **A2** will be exhausted outside the computer case **10** by the cooling fan **30** through the heat dissipation through hole **23** of the case cover **20**.

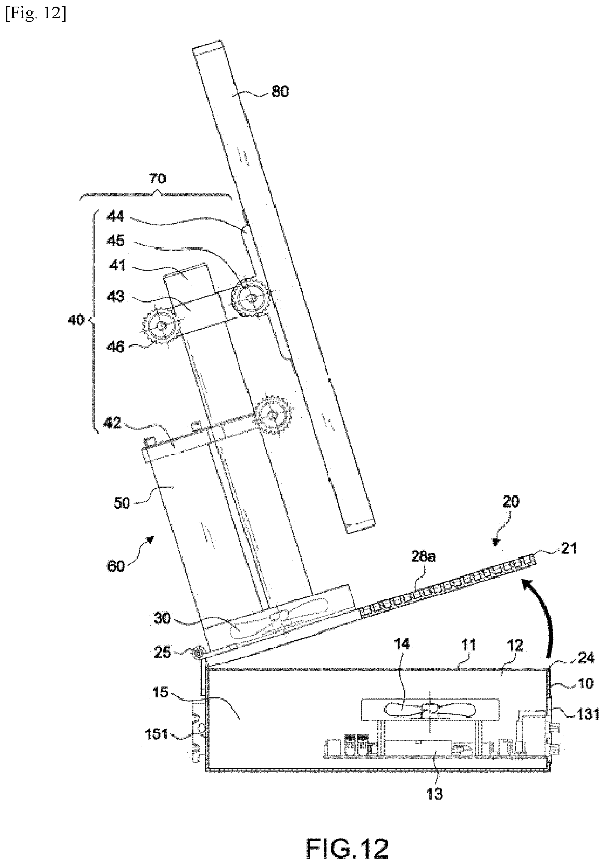

As FIG. 12 showing, since the two corner of the rear section of the case cover **20** have the pivot mechanisms **25** with hinge, and the two corner of the front section of the computer case **10** have securing mechanisms with the screw hole **24** or other devices that can have quick fastening function, the case cover **20** can be lifted off with the whole assembling bracket kit **40** that arranged with the power supplier **50** and the monitor **80**, so the user does not need to remove any device for doing the maintenance task inside the computer case **10**.

The monitor assembling positioning kit **43** of the present invention has adjustment function, as FIG, 13 showing; wherein the connecting unit of the monitor **80** has a pivot **45** and an adjustment unit **46**, the adjustment unit **46** can include but not limited: a bolt with rotate button, the counterclockwise rotation of the adjustment unit **46** loosen the clamping rod **47** holding to the upright structure **41**, and the clockwise rotation of the adjustment unit **46** fasten the clamping rod **47** holding to the upright structure **41**, therefore, by the rotation of the adjustment unit **46** can adjust the position of the monitor assembling positioning kit **43** corresponding to the upright structure **41**, and further achieve the purpose of adjusting the height of the monitor **80**; the pivot **45** also has a bolt with rotate button, loosen the rotate bolt can rotate the pivot **45** with the junction **44** can achieve the purpose of adjusting the elevation angle adjustment of the monitor **80**.

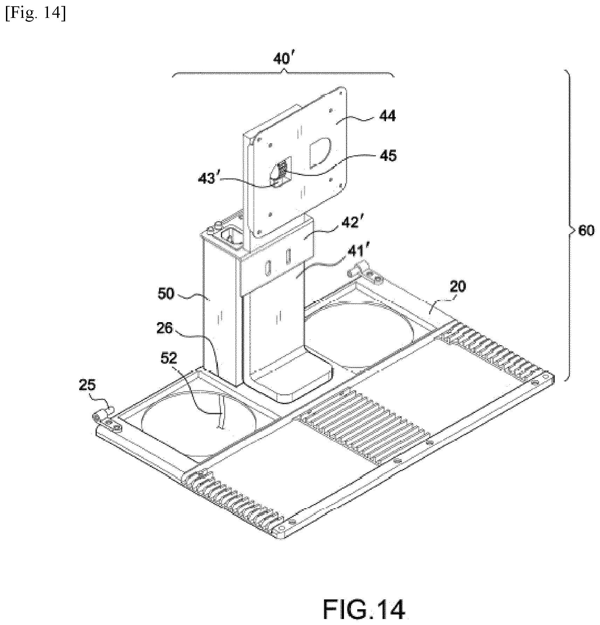

FIG. 14 is illustrating structure of the assembling bracket kit **40'** in another embodiment, the same unit with the above embodiment is marked with same number, the differences are: the upright structure **41'** is rectangle or section of the rectangle, and the power supplier assembling positioning kit **42'** and the monitor assembling positioning kit **43'** coordinate with the section of the upright structure **41'** being arranged at the outer periphery of the upright structure **41'**, and the monitor assembling positioning kit **43'** can also adjust the height of the monitor **80** corresponding to the upright structure **41'**; and the junction **44** and the pivot **45** is the same. In this embodiment, the modular base **60** compose by the assembling bracket kit **40'** has the same feature to the above embodiment.

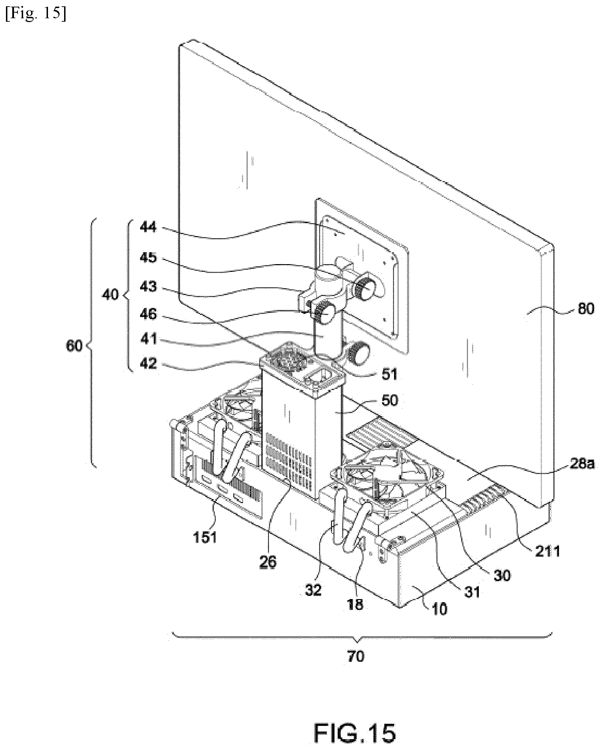

FIG. 15 is a perspective view of the cooling fan **30** in another embodiment, the cooling fan **30** includes a water cooling radiator **31** and a water cooling pipe **32**, and the rear side of the computer case **10** has a hard tube water cooling device **18**; The water cooling radiator **31** in this embodiment has better heat dissipation effect than the above embodiment.

With the features disclosed above, the present invention has below improved effect:
1. The present invention can choose the display card **15**, the mainboard **13** and the first suction fan **14** to be arranged inside the computer case **10** by requirement, above them is a case cover **20** with predetermined cooling fan **30** and the interval plate **21**, via the air suction hole **211** suck in the external air and go through the heat dissipation through hole **23** of the rear section of the case cover **20** to form a high effect heat dissipation system; and secure the assembling bracket kit **40** of the power supplier **50** and the monitor **80** on the case cover **20** for forming an all-in-one computer with a predetermined monitor **80** and related units, and arranged the predetermined power supplier **50** outside the computer case **10** can avoid the heat dissipation problems, so the all-in-one computer has the benefits of reducing the space that computer taken on the desk and extending the life of components.
2. The present invention not only completely separate the predetermined monitor **80** and the power supplier **50** which are the main heat source, but also has a computer case **10** that can exchange air, only two main heat source main board **13** and display card **15** is left inside, so the heat dissipating speed and effect are better that conventional technique.
3. The present invention can set the mainboard **13** I/O ports at the user's reachable location, so the user can directly use the USB 3.0, USB3.1, USB 4 and Thunderbolt of the mainboard **13**, so as to have the effect of expanding hardware conveniently.
4. At the rear side of the case cover **20** and the computer case has a pivot mechanism **25**, the user only needs to unlock the locking mechanism of the front side of the case cover **20** and the computer case **10**, then the case cover **20** is able to be open together with the power supplier **50** and the predetermined monitor **80** which installed with assembling bracket kit **40**, so the user does not need to remove any device to do assembling and maintaining task inside the computer case.

Although particular embodiments of the invention have been described in detail for purposes of illustration, various modifications and enhancements may be made without departing from the spirit and scope of the invention. Accordingly, the invention is not to be limited except as by the appended claims.

## Claims

1. A modular computer case sharing monitor assembling bracket with power supplier, comprising:
a computer case **(10)**, which is a horizontal PC case having an upward opening **(11)**, inside the opening **(11)** has a containing space **(12)** for installing related computer units, the rear side of the computer case **(10)** has a first opening **(151)** for installing a predetermined I/O port of a display card **(15)**, at the other side of the computer case **(10)** has a second opening **131** for installing a predetermined I/O port of a mainboard **(13)**;
a case cover **(20)** set at the opening **(11)** of computer case **(10)**, the case cover **(20)** has multiple air suction holes **(211)** arranged at the front section; the rear section of the case cover **(20)** has at least an upward heat dissipation through holes for installing at least a predetermined cooling fan or water cooling radiator with fan, the multiple air suction holes **(211)** allow the predetermined fan inside the computer case **(10)** to suck in the outside air and then go through the heat dissipation through holes **(23)** and to form a high-speed cooling ventilation system, and a mounting hole **(26)** for arranging a predetermined power supplier **(50)**;
an assembling bracket kit **(40)** having an upright structure **(41)**, a power supplier assembling positioning kit **(42)** arranged at the outer periphery of the upright structure **(41)**, and a monitor assembling positioning kit **(43)**, wherein the power supplier assembling positioning kit **(42)** and the monitor assembling positioning kit **(43)** are arranged at the outer periphery of the upright structure **(41)**, and the bottom end of the upright structure **(41)** is secured on the case cover **(20)**, the monitor assembling positioning kit **(43)** further has a junction **(44)** at the front side for making the case cover **(20)** and the assembling bracket kit **(40)** composing a modular base **(60)**; and
the modular base **(60)** can be installed quickly on the computer case **(10)** to form a modular computer case **(70)** sharing monitor assembling bracket with power supplier **(50)**.

2. The modular computer case sharing monitor assembling bracket with power supplier as claimed in claim 1, wherein the related computer units can be contained inside the computer case **(10)** including: a mainboard **(13)**, a first suction fan **(14)**, a display card **(15)**, and a second suction fan **16** which combined on the display card **(15)**, and inside the case cover **(20)** can arrange a PCIe slot **(17)** for installing PCIe extension cable, the PCIe slot **(17)** is arranged correspondingly to the display card **(15)** and the mainboard **(13)**.

3. The modular computer case sharing monitor assembling bracket with power supplier as claimed in claim 2, wherein the heat dissipation through holes **(23)** is for installing a predetermined cooling fan **(30)**, using the first suction fan **(14)** and second suction fan **(16)** to suck in the outside cold air **(A1)** and then exhaust the heat **(A2)** inside the computer case **(10)** by the predetermined cooling fan **(30)**, the predetermined cooling fan **(30)** includes a water cooling radiator **(31)**.

4. The modular computer case sharing monitor assembling bracket with power supplier as claimed in claim 1, wherein the composition of the air suction holes **(211)** includes: at least an air suction port **(22)** arranged at the front section of the case cover **(20)**, and on the any side of the air suction port **(22)** has multiple interval plates **(21)**; a first-type cover mask **(28a)** having multiple first hollow holes **(281)** arranged at the front section of the case cover **(20)** for making interval plates **(21)** to be partial exposed, and the first-type cover mask **(28a)** is covered on the air suction port **(22)** and the interval plates **(21)** of the case cover **(20)** for making the air suction port **(22)** and the interval plates **(21)** form multiples passages or through holes that avoid foreign objects and electromagnetic wave leakage by sucking in the outside air from lateral side.

5. The modular computer case sharing monitor assembling bracket with power supplier as claimed in claim 4, wherein the air suction port **(22)** at the front section of the case cover **(20)** and the heat dissipation through hole **(23)** at the rear section further include a second-type cover mask **(28b)** with larger area, the second-type cover mask **(28b)** not only has the first hollow holes **(281)** arranged at the first-type cover mask **(28a)** but also has a second hollow hole **(282)** that make the mounting holes **(26)** and the positioning hole **(27)** to be exposed at the rear section of the case cover **(20)**, the second-type cover mask **(28b)** covers the air suction port **(22)** and part of the interval plates **(21)**, between each of the interval plates **(21)** remain the air suction holes **(211)** for exchanging air; the second-type cover mask **(28b)** has multiple meshes **283** arranged correspondingly to the arrangement of the heat dissipation through holes **(23)**, and the predetermined cooling fan **(30)** can be arranged below the heat dissipation through holes **(23)** and not be protruding out of the top surface of the case cover **(20)**.

6. The modular computer case sharing monitor assembling bracket with power supplier as claimed in claim 1, wherein the structure of the air suction holes **(211)** is multiple air suction holes **(211)** form in one piece at the front section of the case cover **(20)**.

7. The modular computer case sharing monitor assembling bracket with power supplier as claimed in claim 1, wherein the mounting holes **(26)** of the computer case **(10)** is for installing with the bottom of the power supplier **(50)**, using the power supplier assembling positioning kit **(42)** to secure the predetermined power supplier **(50)** at the lateral side of the upright structure **(41)** to let the exhaust mesh **(51)** which arranged on the top of the power supplier **(50)** be installed upward and be exposed outside the computer case **(10)**, and the mounting holes **(26)** can let the predetermined power supply cable **(52)** of the power supplier **(50)** to set through and further make the computer units inside the computer case **(10)** to be electrically connected, and the case cover **(20)** has a positioning hole **(27)** corresponds to the bottom of the upright structure **(41)** to secure the upright structure **(41)** on the case cover **(20)** by a positioning unit.

8. The modular computer case sharing monitor assembling bracket with power supplier as claimed in claim 1, wherein the shape of the upright structure **(41)** includes column, bar, and plate.

9. The modular computer case sharing monitor assembling bracket with power supplier as claimed in claim 1, wherein the front side of the junction **(44)** of the monitor assembling positioning kit **(43)** is for installing a predetermined monitor **(80)**, and the monitor assembling positioning kit **(43)** further includes a pivot **(45)** and an adjustment unit **(46)** in order to adjust the height of the monitor assembling positioning kit **(43)** according to the upright structure **(41)** and to adjust the angle of the predetermined monitor **(80)** according the monitor assembling positioning kit **(43)**.

10. The modular computer case sharing monitor assembling bracket with power supplier as claimed in claim 1, wherein at the rear side of the case cover **(20)** and the computer case **(10)** has a pivot mechanism **(25)** for making the case cover **(20)** able to be open for assembling and maintaining task inside the computer case **(10)**.
